Europäisches Patentamt

European Patent Office

Office européen des brevets

(11) Publication number: **0 295 006 A2**

# EUROPEAN PATENT APPLICATION

(21) Application number: 88305043.7

(22) Date of filing: 02.06.88

(51) Int. Cl.⁴: **G01V 9/04**

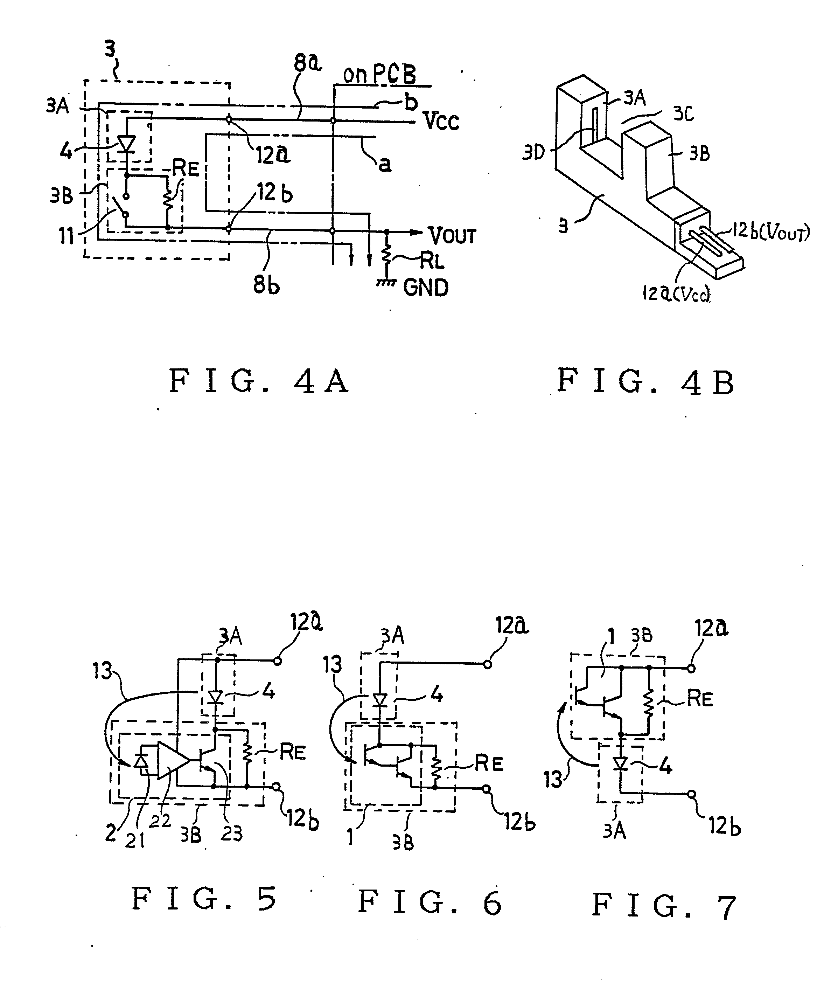

A request for correction of clerical errors in figures 7,8 and 10 has been filed pursuant to Rule 88 EPC. A decision on the request will be taken during the proceedings before the Examining Division (Guidelines for Examination in the EPO, A-V, 2.2).

(30) Priority: **10.06.87 JP 143225/87**

(43) Date of publication of application:
**14.12.88 Bulletin 88/50**

(84) Designated Contracting States:
**DE FR GB**

(71) Applicant: **KABUSHIKI KAISHA TOSHIBA
72, Horikawa-cho Saiwai-ku
Kawasaki-shi Kanagawa-ken 210(JP)**

(72) Inventor: **Katayama, Takao c/o Patent Division
Toshiba Corp.Principal Office 1-1 Shibaura
1-chome
Minato-ku Tokyo(JP)**

(74) Representative: **Sturt, Clifford Mark et al
MARKS & CLERK 57-60 Lincoln's Inn Fields
London WC2A 3LS(GB)**

(54) **An optical sensor.**

(57) The present invention provides an optical sensor having only two terminals. The first terminal (12a) is supplied with a bias voltage, and the second terminal (12b) is connected to supply an output voltage to a subsequent circuit. The optical sensor comprises circuit means for regulating the current flowing therethrough, including photo-emitting means (4) for emitting light and photo-receiving means (11) aligned for receiving light from the photo-emitting means along an optical path, for changing the level of the current when the optical path is interrupted.

FIG. 4A

## AN OPTICAL SENSOR

This invention concerns an optical sensor having a photo-emitting element and a photo-receiving element. More particularly, this invention relates to an optical sensor used for sensing the presence of an object.

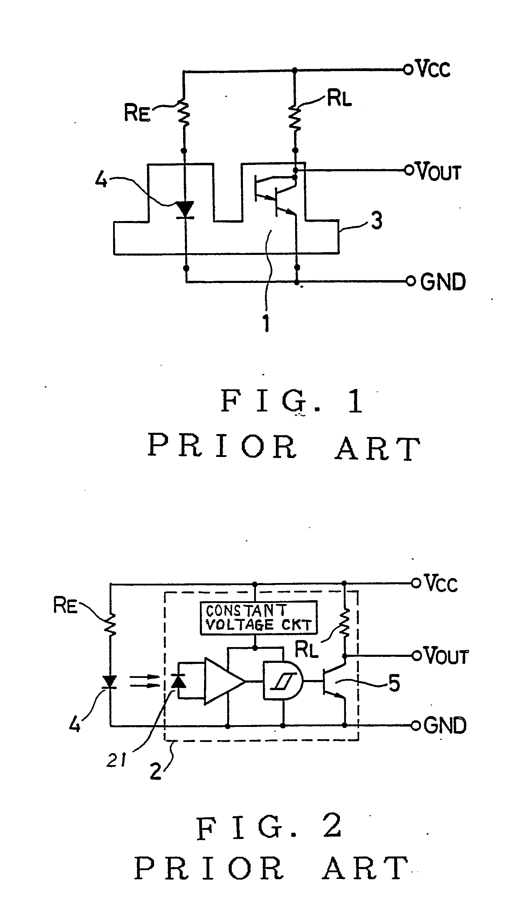

As a basic element of an optical sensor, a photo-interrupter is widely used. The typical photo-interrupter comprises a photo-emitting element and a photo-receiving element, which are packaged in a housing, with an optical path between them to allow for an interruption by an object to be sensed. Conventionally, the circuit arrangements shown in **FIGS.1** and **2** are generally used in the application of the photo-interrupter. In **FIG.1**, a photo-transistor **1** is used as the photo-receiving element.

In **FIG.2**, an integrated circuit **2** including an photo-diode **21** is used as the photo-receiving element.

In **FIG.1**, numeral **3** designates a photo-interrupter including a photo-emitting diode **4** and a photo-transistor **1**. **RE** and **RL** are resistors. **VCC**, **VOUT**, and **GND** designate a voltage terminal, an output terminal and an earth or ground terminal, respectively. In this construction, these three terminals **VCC,VOUT** and **GND** are required. A change of voltage at the **VOUT** terminal, in accordance with the ON or OFF state of the photo-transistor **1**, is transferred as an output to a following circuit (not shown). The ON and OFF state of the photo-transistor **1** is controlled by the interruption of an optical path between the light-emitting diode **4** and the photo-transistor **1** by an object. The resistor **RE** limits the current flowing to the photo-emitting diode **4**. The resistor **RL** connected serially between the **VCC** terminal and the **VOUT** terminal develops an output. At the present time, a photo-interrupter device having three terminals like the circuit shown in **FIG.1** or **FIG.2** packaged within a housing is widely used in. e.g., photo-copiers for sensing the operation thereof.

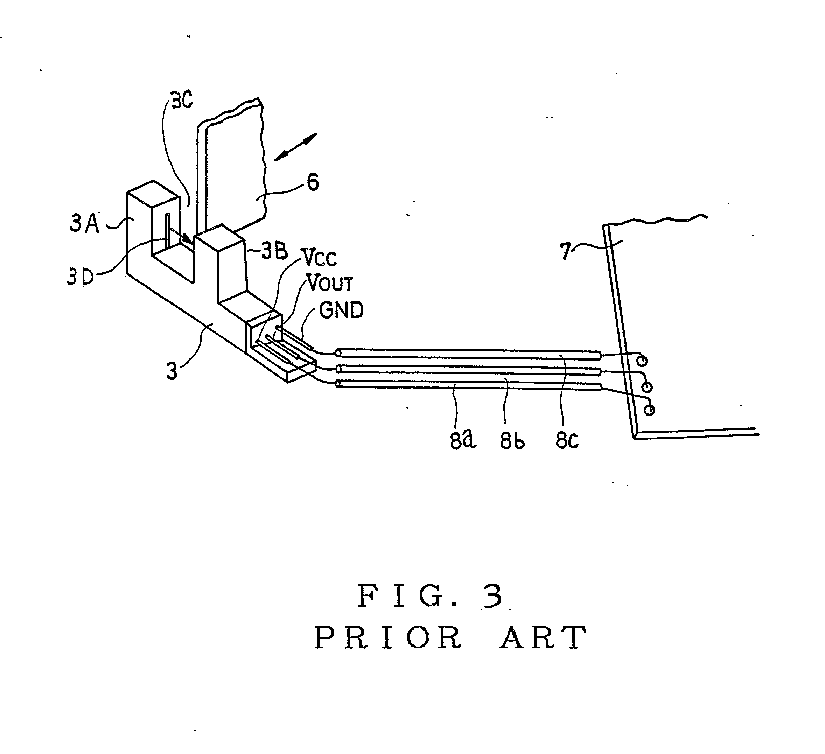

**FIG.3** shows an external appearance of the conventional three terminal photo-interrupter, and an arrangement for sensing an object **6** using the three terminal photo-interrupter. In the drawing, numeral **3** designates the three terminal photo-interrupter. In the photo-interrupter **3**, the photo-emitting element and the photo-receiving element are packaged in projecting portions **3A** and **3B**, respectively. The light from the emitting element is emitted through a window **3D** and transferred to the photo-receiving element through an optical path formed in the channel **3C** and another window (not shown) formed at the projecting portion **3B** corresponding to the location of the photo-receiving element. The channel portion **3C** permits interruption of the optical path by the insertion of the object **6**. When the object **6** interrupts the optical path, the photo-receiving element changes to the OFF state. The three terminals **VCC, VOUT** and **GND** are connected by three conductive wires **8a, 8b** and **8c** to a printed circuit board (PCB) **7**. on which many kinds of circuits are formed.

(i) In the conventional construction, at least three conductive wires are required to connect the photo-interrupter to a following circuit. Thus. a corresponding amount of space is required. Therefore, the conventional photo-interruptor sometimes is not suitable when many photo-interrupters are necessary, because there is insufficient space available to accommodate all the needed photo-interrupters.

(ii)Inspection and protection for short or open circuits with respect to the three wires. Thus the following circuit becomes complicated due to the need for a protection circuit.

(iii)when the output transistor **5** in **FIG.2** is OFF, the output impedance of the photo-interrupter is determined by the resistance RL. In this case, if the input impedance of the following circuit is high, no current flows on the conductive wire connected to the **VOUT** terminal. Thus, the wire is easily influenced by radio frequency interference. Consequently, the rate of faulty operation is increased.

Accordingly, an object of this invention is to provide a photo-sensor which is more compact and easier to install.

Another object of the invention is to provide an optical sensor which is resistant to the influence of radio frequency interference.

A more specific object of the invention is to provide an improved optical sensor having only two terminals.

This invention provides an optical sensor, comprising:

circuit means for regulating a current flowing therethrough including photo-emitting means for emitting radiation and photo-receiving means aligned for receiving radiation from the photo-emitting means along an optical path for changing the level of the current when the optical path is interrupted; and

terminal means connected to the circuit means including only two terminals, one terminal for supplying a predetermined bias voltage to the circuit means, and the other terminal for receiving a variable output voltage from the circuit means corresponding to the level of current in the circuit means.

Embodiments of the invention will now be described by way of example only and with reference to the accompanying drawings, in which :-

Fig. 1 is a circuit diagram of a conventional optical sensor,

Fig. 2 is another circuit diagram of a conventional optical sensor,

Fig. 3 is a perspective view of the conventional three terminal photo-interrupter,

Fig. 4A is a circuit diagram of an optical sensor forming one embodiment of the present invention,

Fig. 4B is a perspective view of the optical sensor of this invention.

Figs. 5 to 7 are circuit diagrams of alternative arrangements of the embodiment of Fig. 4A,

Fig. 8 is a test circuit diagram for explaining the characteristics of the embodiment of Fig. 4A,

Fig. 9 is an enlarged view of the spacing between the photo-emitting element and the photo-receiving element of the embodiment of Fig. 4A,

Fig. 10 is a circuit diagram of another embodiment of this invention,

Figs. 11 to 13 are circuit diagrams of alternative arrangements for the embodiment shown in Fig. 10,

Fig. 14 is a test circuit diagram for explaining the characteristics of the embodiment of Fig. 10,

Fig. 15 is an enlarged view of the spacing between the photo-emitting element and the photo-receiving element of the embodiment of Fig. 10.

Referring now to the drawings, like reference characters designate like or corresponding parts throughout the several views.

In Fig. 4A, the photo-receiving element is shown as a switch 11. The switch 11 becomes ON or OFF in accordance with the presence of the light from the photo-emitting element 4. The resistor RE is connected in Parallel to the switch 11.

The photo-emitting element 4 is packaged in the projecting portion 3A, and the photo-receiving element 11 is packaged in the projecting portion 3B, shown in Fig. 4B. The power terminal lead 12a(VCC) and the out terminal 12b(VOUT) protrude from the housing 3, as shown in Fig. 4B. When the switch 11 is OFF, current flows in route a, namely through the photo-emitting element 4 and the resistor RE. The current is expressed as follows.

$$IOUT(OFF) = \frac{VCC-VF}{RE+RL} \qquad \dots(1)$$

wherein

VCC: voltage at voltage power supply terminal **VCC**,

VF : forward voltage of the photo-emitting element **4**.

RL ; resistance value of the resistor **RL**

RE ; resistance value of the resistor **RE**

Namely, when the photo-receiving element is in the OFF state, the current flowing to the photo-emitting element **4** is restricted by the resistance RE and RL.

On the other hand, when the switch **11** is ON, current flows in route **b**. The current IOUT(ON) is expressed as

$$IOUT(ON) = \frac{VCC-VF}{RL} \qquad \dots(2)$$

The output current is supplied to the load resistor **RL** on the PCB. As apparent from the equations (1) and (2), in spite of the ON or OFF state of the photo-receiving element, a predetermined current flows in the conductive wire **8b**, which transfers the output signal. Thus, this construction is resistant to the influence of radio frequency interference.

Furthermore, only two electrically conductive wires are required to connect the photo-interrupter to the following circuit. Thus the required space and the assembly steps are reduced.

In **FIG.5**, an integrated circuit **2**, including a photo-diode **21**, an amplifier **22** and an output transistor **23**,

3

is used as the photo-receiving element. Numeral 13 represents a light passing from the photo-emitting element 4 to the photo-receiving element.

In FIG.6, a photo-transistor 1 is used as the photo-receiving element.

In FIG.7, the placement of the photo-emitting element 4 and the photo-receiving element 1 is reversed. In these arrangements, it is preferable that the photo-receiving element have a larger driving capacity than that of the photo-emitting element to absorb all current flowing to the photo-emitting element.

In these embodiments, only two terminals are required for the photo-interrupter. Furthermore, a predetermined minimum current normally flows on the output line. Thus, problems, such as the space problem and the influence of radio frequency interference, are solved.

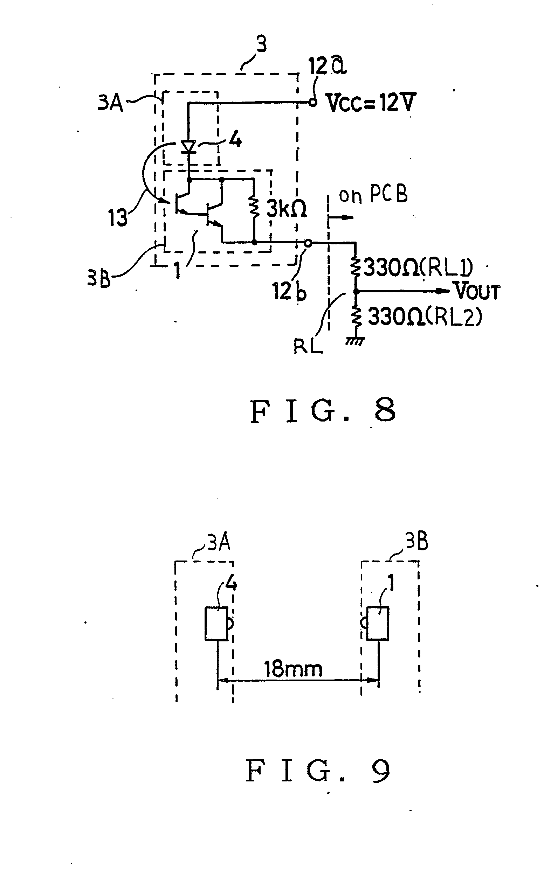

FIG.8 shows an test circuit diagram. In the test circuit, commercial products designated TLN107A and TPS617 both available from Toshiba Corporation, were used for the photo-emitting element 4 and the photo-receiving element 1, respectively. The spacing between the elements 1 and 4 was set to about 18mm, as shown in FIG.9. As the load resistor RL, a serial connection of two resistors RL1 and RL2 was used. The voltage at the common junction of the resistors was obtained as the output voltage. The output voltage VOUT was as follows.

$$VOUT(ON) \simeq 4.9V$$
$$VOUT(OFF) \simeq 1V$$

These output values are sufficient for use as input signals to a following circuit, even if constructed by a CMOS circuit. Thus, by connecting a load resistor in the outer circuit between the VOUT terminal and ground, an optical sensing circuit can be obtained for a two terminal photo-interrupter.

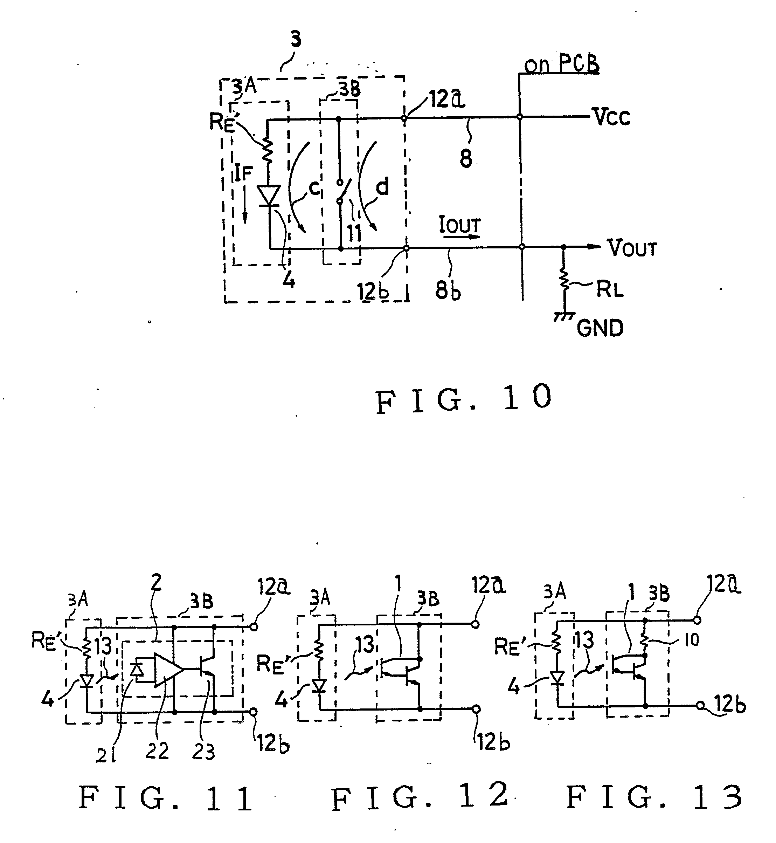

FIG.10 shows another embodiment of this invention. In this embodiment, the series connection of the resistor $RE'$ and the photo-emitting element 4 is connected in parallel to the photo-receiving element, illustrated as a switch 11, between the power terminal 12a and the output terminal 12b. It is assumed that the switch 11 passes a current n times the current IF which flows through the photo-emitting element 4 in the ON state thereof. In this embodiment, when the switch 11 is OFF, current flows on route c. The output current is supplied to the load resistor RL through the conductive wire 8b.

The output voltage VOUT(OFF) is expressed as follows;

$$VOUT(OFF) = \frac{RL \cdot (VCC-VF)}{(RE'+RL)} \quad \cdots (3)$$

When the switch 11 is ON, the output voltage is expressed as follows;

$$VOUT(ON) = \frac{(1+n) \cdot RL \cdot (VCC-VF)}{RE'+(1+n) \cdot RL} \quad \cdots (4)$$

In this embodiment, a predetermined minimum current flows normally on the conductive wire 8b. Furthermore, only two conductive wires are required.

FIGS.11 to 13 show modifications to the embodiment shown in FIG.10.

In FIG.11, an integrated circuit 2, including an photo-diode 21, an amplifier 22 and an output transistor 23, is used as the photo-receiving element.

In FIG.12, a photo-Darlington transistor 1 is used as the photo-receiving element.

In FIG.13, a current limiting resistor 10 is connected in series between the photo-Darlington transistor 1 and the terminal 12a.

In the construction of FIG. 10, the following relationship between the output voltage VOUT(OFF) and the VOUT(ON) is preferable when a circuit constructed of a TTL or a CMOS is used as a following circuit.

$$\frac{VOUT(ON)}{VOUT(OFF)} > 4 \quad \cdots (5)$$

4

Using the equations (3), (4) and (5), the following equations are obtained.

$$n > 3 \quad \dots (6)$$

$$\frac{RE'}{RL} > \frac{3 \cdot (1+n)}{(n-3)} \quad \dots (7)$$

Thus, the photo-receiving element 11 is required to carry a current at least three times the current which flows through the photo-emitting element 4.

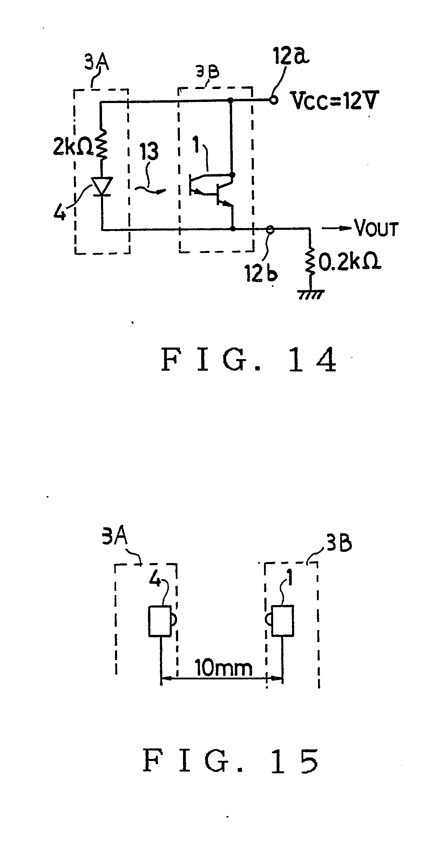

FIG.14 shows a test circuit diagram, and FIG.15 shows the spacing between the photo-emitting element 4 and the photo-receiving element 1 of the embodiment shown in FIG.10. In the test circuit, a 2 KΩ resistor was used to limit the current of the photo-emitting element 4, and a 0.2KΩ resistor was used as the load resistor. The voltage developed at the load resistor is obtained as the output voltage VOUT.

As the photo-emitting element 4 and the photo-receiving element 1, commercial components designated as TLN107A and TPS617 (both available from Toshiba Corporation) were used, respectively. The output voltage VOUT(ON) and VOUT(OFF) was obtained as follows;

VOUT(OFF) ≃ 1V

VOUT(ON) ≃ 5V

These output voltages would be sufficient even if a CMOS circuit is used as the following circuit.

The present invention has been described with respect to specific embodiments. However, other embodiments based on the principles of the present invention will be apparent to those of ordinary skilled in the art. Such embodiments are covered by the appended claims.

### Claims

1. An optical sensor, characterized by comprising:

circuit means for regulating a current flowing therethrough, including photo-emitting means (4) for emitting radiation and photo-receiving means (11) aligned for receiving radiation from the photo-emitting means (4) along an optical path, for changing the level of the current when the optical path is interrupted; and

terminal means (12a, 12b) connected to the circuit means including only two terminals, one terminal for supplying a predetermined bias voltage to the circuit means, and the other terminal for receiving a variable output voltage from the circuit means corresponding to the level of current in the circuit means.

2. An optical sensor as claimed in claim 1, characterized in that the photo-receiving means (11) comprises a photo-detector (1, 2) and a resistor (RE) connected in parallel for maintaining a predetermined minimum current flow in the circuit means.

3. An optical sensor as claimed in claim 2, characterized in that the photo-detector comprises an integrated circuit (2) having a photo-diode (21) therein.

4. An optical sensor as claimed in claim 2, characterized in that the photo-detector comprises a photo-transistor (1).

5. An optical sensor as claimed in claim 1, characterized in that the circuit means includes means for connecting the photo-emitting means (4) and the photo-receiving means (11) in parallel for maintaining a predetermined minimum current flow in the circuit means.

6. An optical sensor as claimed in claim 5, characterized in that the photo-receiving means (11) comprises an integrated circuit (2) having a photo-diode (21) therein.

7. An optical sensor as claimed in claim 5, characterized in that the photo-receiving means (11) comprises a photo-transistor (1).

8. An optical sensor as claimed in claim 7, characterized in that the photo-receiving means (11) further comprises a resistor (10) connected to the photo-transistor (1) for limiting the current supplied thereto.

F I G. 1
PRIOR ART

F I G. 2
PRIOR ART

FIG. 3
PRIOR ART

F I G. 4 A

F I G. 4 B

F I G. 5    F I G. 6    F I G. 7

F I G . 8

F I G . 9

FIG. 10

FIG. 11    FIG. 12    FIG. 13

FIG. 14

FIG. 15